**Europäisches Patentamt**

**European Patent Office**

**Office européen des brevets**

⑩

(11) Publication number: **0 136 534**
**B1**

(12) # EUROPEAN PATENT SPECIFICATION

(45) Date of publication of patent specification: **13.06.90**

(21) Application number: **84110227.0**

(22) Date of filing: **28.08.84**

(51) Int. Cl.⁵: **G 03 F 7/16**

(54) **Method of forming a large surface area integrated circuit.**

(30) Priority: **06.09.83 US 529436**

(43) Date of publication of application:
**10.04.85 Bulletin 85/15**

(45) Publication of the grant of the patent:
**13.06.90 Bulletin 90/24**

(84) Designated Contracting States:
**AT BE CH DE FR GB IT LI LU NL SE**

(56) References cited:
**EP-A-0 002 040**
**FR-A-1 227 231**
**FR-A-2 108 569**
**US-A-3 876 465**
**US-A-4 018 940**

(73) Proprietor: **ENERGY CONVERSION DEVICES, INC.**
**1675 West Maple Road**
**Troy Michigan 48084 (US)**

(72) Inventor: **Vijan, Meera**
**1258 Tennysen**
**Troy, MI 48084 (US)**

(74) Representative: **Müller, Hans-Jürgen, Dipl.-Ing. et al**
**Müller, Schupfner & Gauger Maximilianstrasse 6**
**Postfach 10 11 61**
**D-8000 München 1 (DE)**

Courier Press, Leamington Spa, England.

## Description

The invention concerns a method of forming an electronic integrated circuit element comprising the steps mentioned in the opening part of claim 1.

Such methods are known by e.g. EP—A— 0 002 040 and by US—A—4 018 940 which concern solder resistant photoresist compositions consisting of e.g. an epoxy resin and a polyene on the one hand and of a solvent on the other hand. The purpose of these methods is to protect parts of printed circuits during soldering of other parts thereof and to protect the finished printed circuit against the environment. The photoresist material is poured out of a container disposed about 100 mm above the surface to be covered. The photoresist material has a viscosity of between 500 and 1200 mPas falling down from the container onto the surface by a velocity of between 60 and 160 m/min while the element to be covered by the photoresist material moves by a velocity of e.g. 130 m/min. After drying of the photoresist layer atop said surface the thickness of the photoresist layer is between 20 and 22 μm on the upper edges of the conductors while the remaining parts of the photoresist layer are much thicker.

Furthermore, according to other known methods photoresist material is applied onto rigid monocrystalline non-flexible elements by spraying, dipping, spinning or whirling coating processes and eventually by gravure rolling. Most of these methods are unsuitable for both large non-rigid flexible element and for continuous processes.

It is an objective of the present invention to deposit a very thin photoresist layer atop a surface of an electronic integrated circuit element by relatively similar means. The photoresist layer shall be a substantially continuous web which is distinguished from a spray of substantially discontinuous particles. The photoresist layer shall allow to cover surfaces of flexible elements. Furthermore, at least parts of the photoresist layer shall have the capability to be removed very easily from the surface of the element.

The invention is characterized in claim 1 and further embodiments thereof are claimed in subclaims.

According to the invention a viscous liquid comprising photoresist and solvent is extruded through an elongate orifice comprising a thickness of lower than 50 μm. The orifice is disposed in close proximity but spaced from the surface of the electronic circuit element. A distance of between 50 and 250 μm between said orifice and said surface is preferred.

The linear velocity of the circuit element is greater than the linear velocity of the viscous liquid issuing from said orifice so that the viscous liquid is stretched on the way from the orifice to the surface of the element on which the photoresist layer is disposed as a thin wet film at a lesser thickness than the viscous liquid issuing from the orifice.

In order to further decrease the thickness of said thin wet film it is heated to drive off solvent therefrom so that the thickness will reach values between 0,2 and 2 μm on the electronic circuit element surface.

The film of the photoresist composition is then exposed to actinic radiation e.g. through a photomask forming soluble and insoluble portions. The soluble portions of the photoresist film are removed uncovering a patterned portion of the etchable surface. The uncovered portions of the etchable surface are then removed thereby to define a circuit element that is a facsimile or reverse facsimile of the photomask pattern.

The invention is described more detailed by the drawings which show in

Fig. 1 a schematic view of the method where the flexible, mechanical substrate is withdrawn from a roll, passed through amorphous semiconductor deposition means, and thereafter passed through various chambers for photolithography, including extrusion formation of the photoresist, followed by deposition of a subsequent amorphous semiconductor layer atop the etched thin film;

Fig. 2 a schematic view of the formation of the photoresist film separate from the etchable surface layer and deposition of the photoresist on the etchable surface layer with draw down of the photoresist film; and

Fig. 3 an exploded, partial cut-away view of the extrusion head having an orifice therein for forming the film of photoresist material.

According to a particularly preferred exemplification of the invention, there is provided a method of forming an electronic circuit, for example an integrated circuit, on a continuous, flexible, mechanical substrate, where the mechanical substrate has at least one linear surface dimension in excess of 7.5 cm. According to this exemplification the continuous, flexible, mechanical substrate is substantially continuously withdrawn from a roll of substrate material and passed through at least one stage of amorphous semiconductor deposition means. Exemplary amorphous semiconductor deposition means are described in US—A— 4 217 374 and 4 226 898. In this way there is deposited at least one layer of amorphous semiconductor material on the flexible, mechanical substrate. The deposit of amorphous semiconductor material has an etchable external surface, in which it is desired to etch a pattern, e.g., to define, connect, or isolate elements. A film comprising photoresist composition is formed separate from the etchable external surface of the amorphous semiconductor material and is thereafter deposited atop the etchable external surface. A photomask is placed between a source of actinic radiation and the deposited, photoresist film, and the photoresist film is exposed to actinic radiation. This causes regions of relatively high solubility and relatively low solubility to form in the photoresist film. The regions of high solubility are removed, uncovering a pattern corresponding to the photomask or the reverse thereof in the etchable surface of the amorphous semiconductor material, and overlaying the other portions of the amorphous semiconductor material. The uncovered portions of the etchable surface of the amorphous semiconductor material are removed by chemical etchants, forming a pattern corresponding to the photomask or the reverse thereof in the amorphous semiconductor material.

According to the invention herein, the photoresist composition is passed through an orifice to form a film thereof and the thusly formed film of photoresist composition is thereafter deposited on the etchable surface of the circuit element. More particularly, the orifice is an elongate horizontal orifice and the circuit element to be coated moves linearly past the orifice.

Furthermore, the linear velocity of the element intended to be coated is greater than the linear velocity of the photoresist composition issuing through the orifice whereby photoresist composition film is drawn down between the orifice and the etchable surface. That is, the photoresist film is forced through the orifice at a relatively large thickness, i.e., the thickness of the orifice, and the higher linear velocity of the element to be coated thins and stretches the film of photoresist composition to form a deposited film of lesser thickness.

The photoresist may be a negative photoresist, rendered less soluble by illumination whereby to yield a complementary or negative facsimile of the photomask. Alternatively, and more preferably, the photoresist is a positive photoresist which is rendered more soluble by illumination whereby to yield a positive facsimile of the photomask.

Negative photoresists are those in which the illuminated area is rendered insoluble relative to the unexposed or masked areas of the photoresist. Negative photoresist resins are polymers having unsaturation, and are further polymerized by actinic radiation. The resin itself need not be photosensitive, but it must be capable of being rendered insoluble through reaction with a sensitizer. The sensitizer is capable of activation by actinic radiation.

Exemplary negative photoresist resins include the photoactive cinnamates, such as polyvinyl cinnamates, polystyrene-cinnamyl ketones, and polyvinyl cinnamylidene acetates; diallyl phthalate prepolymer resins; and isoprenoid resins.

The photoresist polymers are dispersed or dissolved in a solvent with a sensitizer, i.e., an activator or initiator. Photo sensitizers for negative photoresists are activated by near ultraviolet actinic radiation having wavelengths of 200 to 400 nm.

Exemplary sensitizers for cinnamates and diallyl phthalates include azido compounds, e.g., 4,4'-azido dibenzal aldehyde; nitro compounds such as p-Nitrodiphenyl, and alpha-nitronaphthalene; nitroaniline derivatives such as 4-Nitro-2-chloroaniline, 2,4,6-Trinitroaniline, and 5-Nitro-2-amino toluene; anthrones, such as 2-Keto-3-methyl-1,3-dibenzanthrone; quinones, such as 1,2-Benzanthraquinone, Beta-Chloroanthaquinone, and 9,10-Anthraquinone, diphenyls, such as 4,4i-Tetramethyldiaminodiphenyl ketone and the analogous carbinol, and 4,4i-Tetramethyldiaminohenzophenone; and the thiazolines, such as 1-Methyl-2-benzoylmethylenenaphthothiazoline, 2-Methyl-X-nitro-Beta-naphthathiozole, and 1-Ethyl-2-aretylmethylene-Beta-naphthiazoline. Generally, the amount of sensitizer is from about 0.5 to about 10% by weight, basis weight of polymer, and preferably from about 1.5 to about 3.0% by weight, basis weight of polymer.

Exemplary sensitizers for isoprenoids are azides, including 4,4'-Diazidostilbene, 4,4'-Diazidobenzophenone, 2,6-Di(4i-azidobenzal)-4-methyl cyclohexanone, and 4,4'-Diazidodibenzal acetone. Preferred are the azides with carbonyl linkages. Especially preferred is 2,6-Di-(4i-azido benzal)-4-methyl cyclohexanone, because of its stability and solubility.

Additionally, various stabilizers and additives may be present to retard scum formation and thermal polymerization.

Suitable solvents for negative photoresists include 1,4-Dioxane; aliphatic esters, for example butylacetate, and cellosolve acetate, that is, 2-ethoxy ethyl acetate; cellosolve ethers such as ethylene glycol monoethyl ether, and ethylene glycol monomethyl ether; aromatic hydrocarbons, for example xylene, and ethyl benzene. Alternatively, chlorinated hydrocarbons, such as chlorobenzenes, and methyolyne chloride may be used; ketones, especially acetone and cyclical ketones such as cyclohexanone may be used.

Alternatively, the photoresist material may be a positive photoresist material having a positive photoresist polymer dispersed in a suitable solvent. Positive photoresist polymers are low molecular weight polymers characterized by the substantial absence of unsaturation. A particularly preferred positive photoresist polymer is Novolak resin, a phenol terminated phenol-formaldehyde polymer. Other polymers may be present with the Novolak resin, and monomers thereof can even be polymerized with the phenol-terminated phenol-formaldehyde Novolak resin. These include styrene, methyl styrene, styrenemaleic anhydride, styrene-acrylic acid, styrene-methacrylic acid, melamine, melamine-sucrose benzoate, and the like.

Exemplary positive photoresist sensitizers include quinone diazides, such as Benzoquinone 1,2-diazide-4-sulfochloride, Naphthaquino-1,2-diazide-5-sulfochloride, Naphthoquinone-1,2-diazide-4-sulfochloride, Naphthaquinone-2,1-diazide-4-sulfachloride, the analogous carboxy acid chlorides, and the like. Generally the amount of sensitizer is from about ten weight percent to ninety weight percent, basis weight of resin, and preferably from about 25 to about 50% by weight, basis weight of resin.

Exemplary solvents for positive photoresists include cellosolve ethers such as ethylene glycol monomethyl ether and ethylene glycol monomethyl ether; cellosolve acetates such as ethylene glycol monoethyl ether acetate; aliphatic esters such as butylacetate; aromatic hydrocarbons such as xyline and ethyl benzene; chlorinated hydrocarbons such as chlorobenzene and methylene chloride; and ketones, exemplified by cyclic ketones such as cyclohexanone.

The photoresist compositions are typically supplied in a solution of about 15 to about 45% by weight photoresist polymer in solvent, the composition having a viscosity of from about 50 to about 125 centistokes at 25° centigrade. As herein contemplated, the photoresist composition is diluted to from about 2 to about 8% solids e.g. by adding thinner. By thinners are meant compatable solvents. By reducing the solids content a photoresist composition is obtained having a viscosity of from about 1 to about 20 centistokes. In this way a self supporting, flexible, thin film of photoresist composition may be formed separately from the circuit element to be coated.

The thin, flexible film of photoresist composition is formed by forming a pool of photoresist composition in a trough of an extrusion die and imposing a hydrostatic head across the extrusion die to force the photoresist composition out of the extrusion die through an orifice. The film of photoresist composition is formed in close proximity to the surface to be coated, for example from about 50 μm to about 250 μm from the surface to be coated. As herein contemplated, a thin wall of photoresist composition issues from the orifice and layers on the etchable surface of the circuit element.

The film thickness as applied and prior to any treatment is normally greater than about 5 μm but less than about 103 μm, although thicker and thinner films may be used without deleterious effect.

The film, as deposited, is subjected to a soft bake or a pre-bake process which is carried out with dry air. The soft bake or pre-bake may be a convective process or a resistance heating process. The purpose of the pre-baking is to drive off solvents. Solvents impede exposure, actinic radiation initiated chemical reactions, and development. The pre-bake process is typically carried out temperatures of about about 70° to about 120° centigrade for about 10 min to about 40 minutes, and preferably at temperatures from about 90° to about 105° centigrade at times from about 20 min to 30 min. The exact times and temperatures may be found by routine experimentation. As a result of the pre-bake the thickness of the photoresist deposit is reduced to from about 0.2 to about 2 μm.

Thereafter, the photoresist material is exposed to actinic radiation. Typically the actinic radiation has wavelengths from about 200 to 500 nm. Typically the amount of actinic radiation is from about 4 to about 60 mW/cm² for about 2 to 8 sec and the source of the actinic radiation is a mercury vapor lamp. The exact exposure time and intensity may be found by routine experimentation.

The photoresist is then developed to remove regions of higher relative solubility and while leaving behind regions of lower relative solubility corresponding directly or complimentary to the image of the photo mask. Development may be carried out by immersion, or spray. Development is carried out for times of from about 15 to about 150 sec, and generally from about 30 to about 60 sec. When the development is immersion development, nitrogen bubble agitation may be used. After development the surface is rinsed, for example with deionized water.

Spray development is particularly preferred because it allows continuous renewal of developing solution at the solution-photoresist interface. Moreover, there is a certain ablative, abrasive, brushing, or washing action of the spray which removes the more soluble fraction of the photoresist material.

Development, and rinsing are followed by drying, for example with air or nitrogen, and by post baking. Post baking is typically carried out at temperatures from about 100° centigrade to about 200° centigrade, whereby to cause the less soluble portion of the photoresist, which remains after development and rinsing, to adhere more strongly to the surface of the electronic circuit element.

After post baking, the etchant is applied to the now uncovered and unprotected surface of the etchable circuit material. Exemplary etchants are dilute solutions of oxidizers, for example, nitric acid; solutions of phosphoric acid, nitric acid and hydrofluoric acid; solutions of boric acid, nitric acid and hydrofluoric acid; solutions of ammonium hydroxide in methanol with a pH of 9; buffered solutions of hydrofluoric acid; and solutions of nitric acid, hydrofluoric acid and water. The solution is an aqueous solution, although an alcohol, such as methanol, ethylene glycol, or glycerine may be added to the acid solution to moderate the etching reaction. After etching the remaining photoreist is removed, for example by abrasion, or by hot, chlorinated hydrocarbon solutions, known in the art as degreasers. These include trichloroethylene, tetrachloroethylene, and mixtures thereof.

Turning now to the Figures:

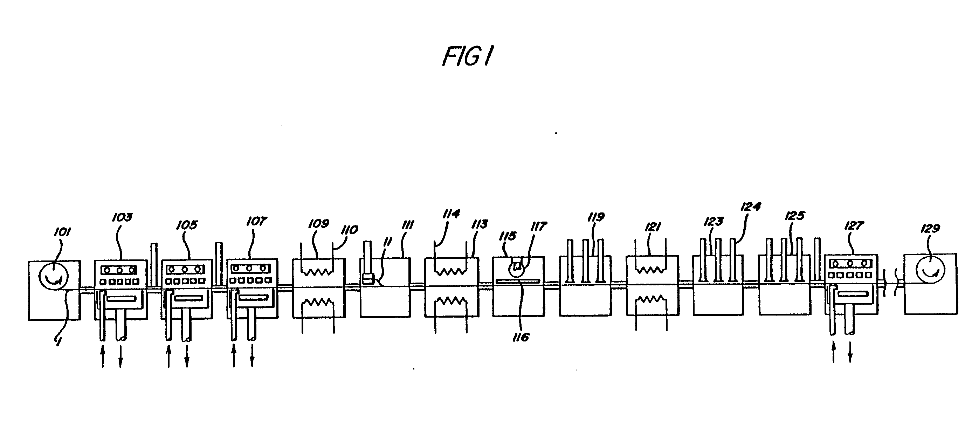

Fig. 1 shows a preferred exemplification of the method of this invention wherein a continuous, flexible, mechanical substrate 1 is withdrawn from a roll 101 of substrate material and passed through three amorphous semiconductor amorphous deposition chambers 103, 105, 107 whereby to deposit three layers of amorphous semiconductor materials. For example, p-type, extrinsic semiconductor material may be applied in deposition chamber 103 followed by intrinsic amorphous silicon semiconductor in deposition chamber 105 and extrinsic, n-type amorphous silicon semiconductor in deposition chamber 107. Thereafter, a thin film or layer of conductive material may be applied atop the n-type extrinsic type semiconductor layer and subsequently have a pattern etched therein. The surface to be etched may be a conductor, a semiconductor, an insulator, or a material settable or switchable between said states. It may be amorphous, polycrystalline, crystalline, or switchable or settable there between, or a mixture thereof. Thus the surface to be etched may be an amorphous semiconductor alloy, or a settable material having a comparatively conductive state and a comparatively non-conductive state, as a chalcogenide.

Etching is a multi-step process which includes pre-treating the electronic circuit element, for example, by heating. Heating chamber 109 may contain resistance heating means 110, or conductive heating means, not shown to heat the semiconductor coated substrate a temperature of about 85°C to about 350°C for from about 10 to 30 min. After heating, the photoresist composition 11 is applied in compartment or chamber 111. It is applied as a film to the integrated circuit element, with a feed of photoresist composition through inlet 21 to an extrusion diehead having an orifice 31 therein.

The substantially continuous circuit element is drawn through the chamber 11 at a constant, linear speed without rotatory or angular velocity or acceleration components. Preferably the linear speed of the continuous circuit element is slightly greater than the linear speed of photoresist composition film 11a from the orifice 31 in the diehead of the extruder 23. This results in a drawdown 116 of the photoresist composition film 11.

The photoresist composition film 11c coated circuit element proceeds out of the coating chamber 111 to a drying chamber 113 where resistance heating elements 114 or conduction provide heating to drive off solvent which may be recovered. This step results in reducing the thickness of the photoresist film by a factor of about 5 to 400.

The photoresist film coated continuous circuit element then proceeds to photographic chamber or compartment 115 where a photomask 116 is placed on the surface thereof and the photoresist film 11 is exposed to actinic radiation through the photomask 116, for example from light source 117. After exposure, the photoresist coated circuit element proceeds to developing and spraying chamber 119 where developer or developer and rinse are sprayed on the surface thereof. This removes regions of relatively high solubility, while allowing regions of relatively low solubility to remain substantially undisturbed thereon.

Next, the photoresist coated circuit element, having a facsimile of the photomask thereon, and with portions of etchable surface uncovered through the photoresist, may be heated, e.g., in chamber 121, to harden the remaining photoresist. Subsequently, the photoresist coated circuit element passes to an etching chamber 123 where an etchant solution is applied thereto through nozzles 124. After etching is substantially complete the etched, photoresist coated circuit element passes to a further chamber 125 for removal of remaining photoresist material. Thereafter the etched continuous integrated circuit may be treated in a subsequent deposition chamber 127, for example to apply a further layer of amorphous semiconductor material or a layer of conductive material. Additionally, there may be further deposition and photoresist steps carried out and the continuous circuit element is drawn up on a roller 129.

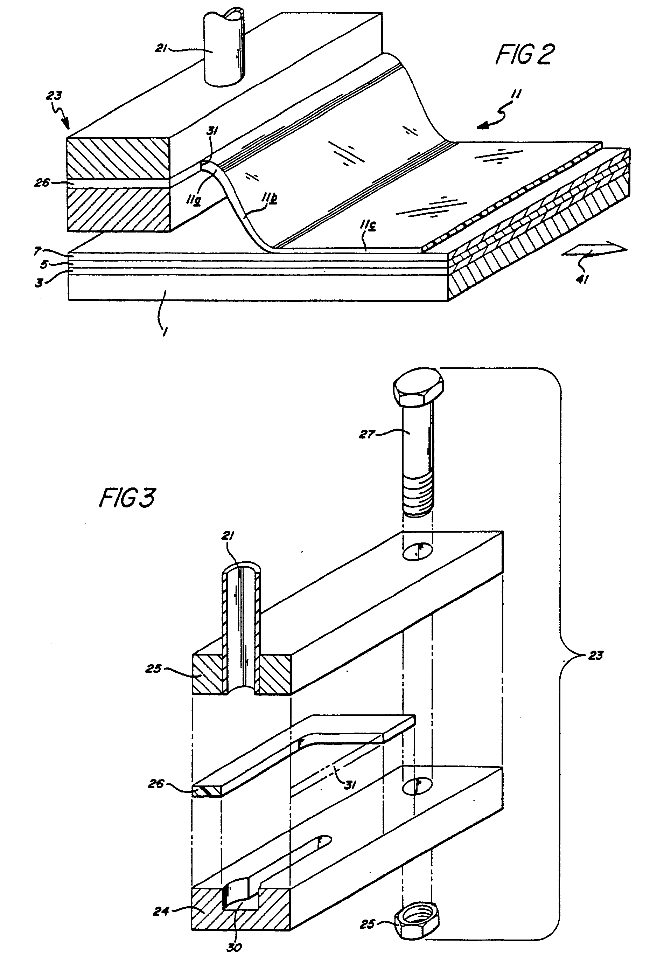

Fig. 2 shows the formation of the photoresist composition film remote from the thin film surface to be etched, and subsequent deposition of the photoresist composition film on the surface to be etched. As shown in Fig. 2 a circuit element having a flexible, mechanical substrate 1 with layers of p-type amorphous silicon semiconductor material 3, intrinsic amorphous silicon semiconductor material 5, and n-type amorphous semiconductor silicon semiconductor material 7 deposited thereon passes under an extruder 23. The extrusion head of said extruder 23 is formed of a bottom half 24 and a top half 25 with a gasket 26 therebetween. Photoresist composition is fed into the extruder head under a positive pressure through feed line 21 and forced out through a substantially horizontal orifice 31. The orifice is spaced from the top layer 7, by about 50 to 250 μm whereby to allow the extruded photoresist film 11 to issue as a relatively thick film of a viscous liquid 11a and be drawn down to film of intermediate thickness 11b and thereafter to a relatively thin film and viscous web 11, resp.

The circuit element moves in a linear direction, 41, with respect to the orifice 31. The circuit element moves at a higher linear velocity than the linear velocity of photoresist film 11 composition issuing from the orifice 31, whereby to draw down the film of photoresist composition. For example, as shown in Figure 2, the photoresist composition is thicker (11a) at the orifice 31 and thinner (11c) as it meets the top layer or surface 7 of the integrated circuit element, because of the draw down effect.

Fig. 3 shows an extrusion die head of an extruder 23 in partial cutaway. The die head has a top portion 25, a bottom portion 24, and a gasket 26 therebetween. The top portion 25 has a photoresist feed line 21 therein. The bottom portion 24 has a trough 30 therein to provide a pool of photoresist composition.

The positive hydrostatic head of photoresist composition in the feed line 21 provides a driving force for the photoresist composition 11 which issues forth from the orifice 31 formed by the notch in the gasket 26. The gasket 26 is typically about 25 about 125 μm thick. The extrusion head is maintained in compression, for example by bolt 27 and nut 25 means shown in the figure.

As shown in Figs. 2 and 3 the photoresist composition is extruded through a slot or die as a film a layer 11 remote from the for surface 7 of the underlying circuit element and forms a viscous web 11c surface thereon.

High pressure in the photoresist composition feed line 21 drives the photoresist composition polymer, solvent, and initiator into and through the die. The film issuing forth from the orifice 31 is less than about 50 μm thick, is for example, preferably from about 2 to about 10 μm thick. The

film issues forth from the extruder die orifice 31 as a thin, unsupported web of a gummy or syrupy liquid, having a viscosity of from about 1 centistoke to about 20 centistokes at 25° centigrade.

The die of the extruder 23 is a t-shaped die, also known as a manifold type flat film die, with adjustable top 25 and bottom 24 portions. That is, they are adjustable through the gasket 26. The die opening or orifice 31 may be equal to the thickness of the desired wet film photoresist material 11 to about 10 times as thick as the desired thickness of the wet film or photoresist material, with thinning being caused by drawn down.

When the die opening or orifice 31 is thicker than the desired thickness of the deposited wet photoresist film or web 11c, the speed of taking up the film on the electronic circuit element or structure to be coated is high enough to significantly drawn down the film with concurrent thinning as described above.

While the method of this invention has been described with respect to integrated circuit elements formed on a flexible, substantially continuous mechanical substrate, capable of being formed in a roll to roll mode, it is to be understood that the method of this invention may also be used in the fabrication of electronic components, or circuit elements characterized by rigid, substantially non flexible mechanical substrates, including crystalline substrates. Additionally, while the method of this invention has been described with respect to integrated circuit elements, it is to be understood that by the term integrated circuit elements is comprehended thereby solar cell panels, display panels, piezo electric input panels, and light sensitive input panels.

## Claims

1. Method of forming an electronic integrated circuit element (1) comprising the steps of:

(1) depositing a photoresist layer (11) atop a surface (7) of the element;

(2) exposing at least portions of the photoresist film (11) to actinic radiation;

(3) developing at least portions of the photoresist film (11);

(4) removing soluble portions of the photoresist (11) to uncover at least portions of the circuit element surface (7); and

(5) processing at least portions of the uncovered circuit element surface (7); to form circuit elements thereon;

characterized in that the depositing step comprises:

a) forming a viscous liquid (11a) comprising photoresist and solvent separate from the electronic circuit element surface (7);

b) forcing the viscous liquid (11a) of a thickness of lower than 50 μm through an elongate, horizontal orifice (31) of an extruder (23) said horizontal orifice (31) being disposed in close proximity to but spaced from the electronic circuit element surface (7) to form a flexible, substantially con-

tinuous viscous web (11b) capable of maintaining its form and integrity between the orifice (31) and the electronic circuit element surface (7);

c) moving the circuit element (1) linearly with respect to said orifice (31) at a linear velocity greater than the linear velocity of the viscous liquid (11a) issuing from said orifice (31) whereby to draw down and stretch the viscous liquid (11a) between the orifice (31) and the electronic circuit element surface (7), thereby depositing a thin wet film (11c) of photoresist on the electronic circuit element surface (7) at a lesser thickness than the viscous liquid (11a) issuing from the orifice; and

d) heating said thin wet film (11c) to drive off solvent therefrom, thereby providing a thin adherent film of photoreist of a thickness of between 0.2 and 2 μm on the electronic circuit element surface (7).

2. Method as claimed in claim 1, characterized in that said thin wet film (11c) of the photoresist layer (11) is deposited on a flexible circuit element formed by a flexible substrate (1) withdrawn from a roll (101) and passed through at least one stage (103) of amorphous semiconductor deposition means whereby to deposit at least one layer of amorphous semiconductor material on the flexible substrate (101) said deposit having an etchable, external surface.

3. Method as claimed in claims 1 or 2, characterized in that said photoresist layer (11) is composed of from about 2 to about 8% by weight solids, balance solvents.

4. Method as claimed in any one of the preceding claims, characterized in that the solids of the photoresist layer (11) are composed of at least phenol terminated phenol formaldehyde photoresist polymer and a quinone diazide photosensitizer thereby forming a positive photoresist.

5. Method as claimed in any one of claims 1—3, characterized in that the solids of the photoresist layer (11) are composed of at least polymers chosen from the group consisting of photoactive cinnamates, diallyl phthallate prepolymer resins, and isopronoid resins, and of photosensitizers chosen from the group consisting of azido compounds, nitro compounds, nitro-aniline derivatives, anthrones, quinones, diphenyls, and thiazolines thereby forming a negative photoresist.

6. Method as claimed in any one of the preceding claims, characterized in that a photoresist composition having a kinematic viscosity at 25°C of from about 1 to about 20 centistokes is used for the photoresist layer (11).

7. Method as claimed in any one of the preceding claims, characterized in that a wet film (11c) of approximately 5 to 103 μm thickness is deposited on the circuit element surface (7).

8. Method as claimed in any one of the preceding claims, characterized in that said orifice (31) of said extruder (23) is disposed in close proximity of from 50 to 250 μm to said circuit element surface (7).

9. Method as claimed in any one of the preceding claims, characterized in that the thickness of said wet film (11c) of photoresist is reduced by a factor of between 5 and 400 during the heating step d.

10. Method as claimed in any one of the preceding claims, characterized in that said photoresist layer (11) is disposed on an etchable circuit element surface (7) which element is formed of a material chosen from the group consisting of substantially amorphous materials being settable from a relatively non-conductive state to a relatively high conductive state.

11. Method as claimed in claim 10, characterized in that said photoresist layer (11) is disposed on a chalcogenide material being settable.

**Patentansprüche**

1. Verfahren zur Herstellung eines elektronischen integrierten Schaltungsbauelements (1), umfassend folgende Schritte:

(1) Aufbringen einer Fotoresistschicht (11) auf eine Oberfläche (7) des Elements;

(2) Bestrahlen von wenigstens Teilen der Fotoresistschicht (11) mit aktinischer Strahlung;

(3) Entwickeln von wenigstens Teilen der Fotoresistschicht (11);

(4) Entfernen löslicher Teile der Fotoresistschicht (11) unter Freilegung von wenigstens Teilen der Oberfläche (7) des Schaltungsbauelements; und

(5) Bearbeiten von wenigstens Teilen der freigelegten Oberfläche (7) des Schaltungsbauelements unter Bildung von Schaltkreiselementen darauf;

dadurch gekennzeichnet, daß der Schritt des Aufbringens folgendes umfaßt:

(a) Bilden einer viskosen Flüssiget (11a), die Fotoresist und Lösungsmittel umfaßt, getrennt von der Oberfläche (7) des elektronischen Schaltungsbauelements;

(b) Pressen der viskosen Flüssigkeit (11a) mit einer Dicke von weniger als 50 um durch eine langgestreckte horizontale Düsenöffnung (31) eines Extruders (23), wobei die horizontale Düsenöffnung (31) in unmittelbarer Nähe zu, jedoch im Abstand von der Oberfläche (7) des elektronischen Schaltungsbauelements angeordnet ist, zur Bildung einer flexiblen, im wesentlichen fortlaufenden viskosen Bahn (11b), die ihre Form und Integrität zwischen der Düsenöffnung (31) und der Oberfläche (7) des elektronischen Schaltungsbauelements aufrechterhalten kann;

(c) Bewegen des Schaltungsbauelements (1) linear in bezug auf die Düsenöffnung (31) mit einer linearen Geschwindigkeit, die höher als die lineare Geschwindigkeit der aus der Düsenöffnung (31) austretenden viskosen Flüssigkeit (11a) ist, so daß die viskose Flüssigkeit (11a) zwischen der Düsenöffnung (31) und der Oberfläche (7) des elektronischen Schaltungsbauelements nach unten gezogen und gestreckt wird, wodurch auf die Oberfläche (7) des elektronischen Schaltungsbauelements ein dünner nasser Fotoresistfilm (11c) aufgebracht wird, dessen Dicke geringer als diejenige der aus der Düsenöffnung austretenden viskosen Flüssigkeit (11a) ist; und

(d) Erwärmen des dünnen Naßfilms (11c) zum Austreiben von Lösungsmittel unter Bildung eines dünnen haftenden Fororesistfilms mit einer Dicke von 0,2—2 µm auf der Oberfläche (7) des elektronischen Schaltungsbauelements.

2. Verfahren nach Anspruch 1, dadurch gekennzeichnet, daß der dünne Naßfilm (11c) der Fotoresistschicht (11) auf ein flexibles Schaltungsbauelement aufgebracht wird, das aus einem von einer Rolle (101) abgewickelten und durch wenigstens eine Stufe (103) einer amorphen Halbleiterabscheideeinheit geführten flexiblen Substrat (1) besteht, so daß auf dem flexiblen Substrat (101) wenigstens eine amorphe Halbleitermaterialschicht abgeschieden wird, die eine ätzfähige Außenfläche aufweist.

3. Verfahren nach einem der Ansprüche 1 oder 2, dadurch gekennzeichnet, daß die Fotoresistschicht (11) aus ca. 2—8 Gew.-% Feststoffen, Rest Lösungsmittel, besteht.

4. Verfahren nach einem der vorhergehenden Ansprüche, dadurch gekennzeichnet, daß die Feststoffe der Fotoresistschicht (11) aus wenigstens phenolterminiertem Phenol-Formaldehyd-Fotoresistpolymer und einem Chinondiazid-Sensibilisator unter Bildung eines positiven Fotoresists zusammengesetzt sind.

5. Verfahren nach einem der Ansprüche 1—3, dadurch gekennzeichnet, daß die Feststoffe der Fotoresistschicht (11) aus wenigstens Polymeren, die fotoaktive Cinnamate, Diallylphthallat-Vorpolymerharze oder Isoprenoidharze sind, und aus Sensibilisatoren, die Azidoverbindungen, Nitroverbindungen, Nitroanilin-Derivate, Anthrone, Chinone, Diphenyle oder Thiazoline sind, unter Bildung eines negativen Fotoresists zusammengesetzt sind.

6. Verfahren nach einem der vorhergehenden Ansprüche, dadurch gekennzeichnet, daß als die Fororesistschicht (11) eine Fotoresistzusammensetzung eingesetzt wird, die eine kinematische Viskosität bei 25°C von ca. 1—20 cSt hat.

7. Verfahren nach einem der vorhergehenden Ansprüche, dadurch gekennzeichnet, daß auf die Oberfläche (7) des Schaltungsbauelements ein Naßfilm einer Dicke von ca. 5—103 µm aufgebracht wird.

8. Verfahren nach einem der vorhergehenden Ansprüche, dadurch gekennzeichnet, daß die Düsenöffnung (31) des Extruders (23) in nahem Abstand von 50—250 µm von der Oberfläche (7) des Schaltungsbauelements angeordnet ist.

9. Verfahren nach einem der vorhergehenden Ansprüche, dadurch gekennzeichnet, daß die Dicke des Fotoresist-Naßfilms (11c) während des Erwärmungsschritts (d) um einen Faktor von 5—400 verringert wird.

10. Verfahren nach einem der vorhergehenden Ansprüche, dadurch gekennzeichnet, daß die Fotoresistschicht (11) auf eine ätzfähige Schaltungsbauelement-Oberfläche (7) aufgebracht wird, wobei das Element aus einem Material besteht, das aus der Gruppe von im wesentlichen amorphen Materialien ausgewählt ist, die aus einem relativ nichtleitfähigen Zustand in einen relativ hochleitfähigen Zustand einstellbar sind.

11. Verfahren nach Anspruch 10, dadurch gekennzeichnet, daß die Fotoresistschicht (11) auf ein einstellbares Chalkogenid-Material aufgebracht wird.

## Revendications

1. Procédé pour former un élément (1) de circuit électronique intégré, comprenant les étapes consistant à:

(1) déposer une couche (11) d'agent de réserve au-dessus d'une surface (7) de l'élément;

(2) exposer au moins des parties de la pellicule (11) d'agent de réserve à un rayonnement actinique;

(3) développer au moins des parties de la pellicule (11) d'agent de réserve;

(4) enlever des parties solubles de l'agent de réserve (11) pr découvrir au moins des parties de la surface (7) de l'élément de circuit; et

(5) traiter au moins des parties de la surface (7) découverte de l'élément de circuit afin de former sur son dessus des éléments de circuit;

caractérisé en ce que l'étape de dépôt comprend les étapes consistant à:

a) former un liquide visqueux (11a) comprenant un agent de réserve et un solvant séparé de la surface (7) de l'élément de circuit électronique;

b) entraîner le liquide visqueux (11a) ayant une épaisseur inférieure à 50 μm à travers un orifice allongé, horizontal (31) d'une extrudeuse (23), l'orifice horizontal (31) étant disposé très près de la surface (7) de l'élément de circuit électronique, mais en en étant espacé, de manière à former un voile visqueux (11b) flexible, sensiblement continu, capable de conserver sa forme et son intégrité entre l'orifice (31) et la surface (7) de l'élément de circuit électronique;

c) déplacer linéairement l'élément de circuit (1) par rapport à l'orifice (31) à une vitesse linéaire supérieure à la vitesse linéaire du liquide visqueux (11a) sortant de l'orifice (31), d'où il résulte la descente et l'étirage du liquide visqueux (11a) entre l'orifice (31) et la surface (7) de l'élément de circuit électronique, d'où le dépôt d'une fine pellicule humide (11c) d'agent de réserve sur la surface (7) de l'élément de circuit électronique à une épaisseur inférieure à celle du liquide visqueux (11a) sortant de l'orifice; et

d) chauffer la fine pellicule humide (11c) pour en extraire le solvant, d'où la production d'une fine pellicule adhérente d'agent de réserve ayant une épaisseur comprise entre 0,2 et 2 μm sur la surface (7) de l'élément de circuit électronique.

2. Procédé selon la revendication 1, caractérisé en ce que la fine pellicule humide (11c) de la couche (11) d'agent de réserve est déposée sur un élément de circuit flexible formé en extrayant un substrat flexible (1) d'un rouleau (101) et en le faisant traverser au moins un étage (103) d'un moyen de dépôt de semi-conducteur amorphe, d'où le dépôt d'au moins une couche de matériau semi-conducteur amorphe sur le substrat flexible (101), le dépôt ayant une surface extérieure pouvant être gravée.

3. Procédé selon les revendications 1 ou 2, caractérisé en ce que la couche (11) d'agent de réserve est constituée d'environ 2 à environ 8% en poids de solides, le reste étant des solvants.

4. Procédé selon l'une quelconque des revendications précédentes, caractérisé en ce que les solides de la couche (11) d'agent de réserve sont constitués d'au moins un polymère d'agent de réserve en phénol-formaldéhyde à terminaison phénol et d'un photosensibilisateur en diazide de quinone, d'où la formation d'un agent de réserve positif.

5. Procédé selon l'une quelconque des revendications 1 à 3, caractérisé en ce que les solides de la couche (11) d'agent de réserve comprenant au moins des polymères choisis dans le groupe constitué des cinnamates photo-actifs, de résines de prépolymère de phtalate de diallyle, et de résines d'isopronoïde, et de photosensibilisateurs choisis dans le groupe constitué des composés azido, des composés nitro, des dérivés de nitroaniline, d'anthrones, de quinones, de diphényles et de thiazolines, d'où la formation d'un agent de réserve négatif.

6. Procédé selon l'une quelconque des revendications précédentes, caractérisé en ce qu'une composition d'agent de réserve ayant une viscosité cinématique à 25°C comprise entre environ 1 et environ 20 centistokes est utilisée pour la couche (11) d'agent de réserve.

7. Procédé selon l'une quelconque des revendications précédentes, caractérisé en ce qu'une pellicule humide (11c) d'environ 5 à 103 μm d'épaisseur est déposée sur la surface (7) de l'élément de circuit.

8. Procédé selon l'une quelconque des revendications précédentes, caractérisé en ce que l'orifice (31) de l'extrudeuse (23) est disposé très près de la surface (7) de l'élément de circuit suivant une distance de 50 à 250 μm.

9. Procédé selon l'une quelconque des revendications, précédentes, caractérisé en ce que l'épaisseur de la pellicule humide (11c) d'agent de réserve est réduite d'un facteur compris entre 5 et 400 lors de l'étape de chauffage d.

10. Procédé selon l'une quelconque des revendications précédentes, caractérisé en ce que la couche (11) d'agent de réserve est disposée sur une surface (7) d'élément de circuit pouvant être gravée, élément qui est constitué d'un matériau choisi dans le groupe comprenant des matériaux sensiblement amorphes pouvant passer d'un état relativement non conducteur à un état relativement hautement conducteur.

11. Procédé selon la revendication 10, caractérisé en ce que la couche (11) d'agent de réserve est disposée sur un chalcogénure pouvant passer entre deux états.

FIG I

101 103 105 107 109 110 11 111 114 113 115 117 119 121 123 124 125 127 129

116

1

EP 0 136 534 B1

FIG 2

FIG 3